# EUROPEAN PATENT APPLICATION

(11) **EP 3 696 849 A1**
(43) Date of publication of application: **19.08.2020**
(21) Application number: 19157762.6
(22) Date of filing: 18.02.2019
(51) Int. Cl.: H01L 23/367, H01L 23/373, H01L 21/48

(54) **A HEATSINK AND A METHOD OF MANUFACTURING A HEAT SINK**

(71) Applicant: ABB Schweiz AG, 5400 Baden (CH)
(72) Inventor: Manninen, Jorma, 00380 Helsinki (FI); Silvennoinen, Mika, 00380 Helsinki (FI); Pakarinen, Joni, 00380 Helsinki (FI)
(74) Representative: Kolster Oy Ab

(57) **Abstract**

1. A heatsink comprising a heatsink base and cooling fins, wherein the heatsink base comprises a first surface which is adapted to be attached to a surface of a heat source and the cooling fins are attached to the heatsink base and arranged to extend from the heatsink base. The heatsink base comprises a second surface comprising grooves, the cooling fins comprise carbon-based material and a metallic base at one end of the fins, and the cooling fins are arranged to the grooves such that the metallic bases are in the grooves.

## Description

### FIELD OF THE INVENTION

The invention relates to cooling devices, and particularly to heatsinks having high efficiency.

### BACKGROUND OF THE INVENTION

Heatsinks are typically used for transferring heat away from a heat source to keep the temperature of the heat source in allowable values. An example of a heat source is a power electronic semiconductor component. Heat is generated in such a component when the switch is operated to and from conducting state. Multiple of power electronic semiconductor components may also be housed in a single structure. This kind of structure is typically referred to as a power electronic module. In a power electronic module multiple of semiconductor components are internally connected together electrically so as to form a certain circuit structure. Power electronic modules are used in power electronic devices, such as converters. A converter may be, for example, a multiphase inverter in which multiple of power semiconductor switches are modulated at a high frequency.

Modern power electronic semiconductor components have been designed to be able to switch high currents and block high voltages. To fully utilize the current and voltage possibilities of power electronic semiconductor components, the cooling of components should be properly designed. The heat is generated in a power electronic semiconductor component in a chip and led from the chip to the bottom of the component. In case of a power electronic module, heat from a multiple of chips is led to the bottom of the module. The bottom of the module may comprise a base plate or the bottom may be formed directly of a bottom surface of a substrate. The heat from the chips is transferred from the bottom to a separate cooling device, such as a heat sink.

Heat sinks typically have a planar surface which is attached to the bottom of the component or module. A heat sink is typically formed from a block of metal which has the planar surface, i.e. a heatsink base and cooling fins extending from the heatsink base. The heat is removed from the heatsink to the surrounding medium which is typically a fluid, such as air or liquid medium. The cooling fins attached to the heatsink base increase the surface area of the heatsink and thus increase the heat transfer from the heat sink to the surrounding air.

Modern power electronic components or modules require efficient cooling so that the full properties of the components or modules can be exploited. Components can be cooled efficiently using liquid cooling. However, liquid cooling may not be suitable for all devices and the costs relating to liquid cooling may be too high for certain devices. Therefore, a more efficient heatsink design with cooling fins is desired.

### BRIEF DESCRIPTION OF THE INVENTION

An object of the present invention is to provide a heatsink and a method of manufacturing a heatsink so as to solve the above problem. The object of the invention is achieved by a heatsink and a method which are characterized by what is stated in the independent claims. The preferred embodiments of the invention are disclosed in the dependent claims.

The invention is based on using cooling fins which are made primarily of carbon based material. The cooling fins are attached to a metallic heatsink base in a manner which enables heat transfer from the heatsink base to the carbon based cooling fins. The cooling fins are preferably sheet-like structures which are attached to grooves which are machined in a surface of the heatsink base. Preferably, the cooling fins have also another structural material which is metal.

In the method of the invention a heatsink of the invention is manufactured. The heatsink of the invention has the advantage that the heat transfer from the heat source is increased due to increased heat transfer from the heatsink base to cooling fins. The cooling fins of the invention transfer heat in an effective manner and thereby increase the efficiency of the heatsink.

### BRIEF DESCRIPTION OF THE DRAWINGS

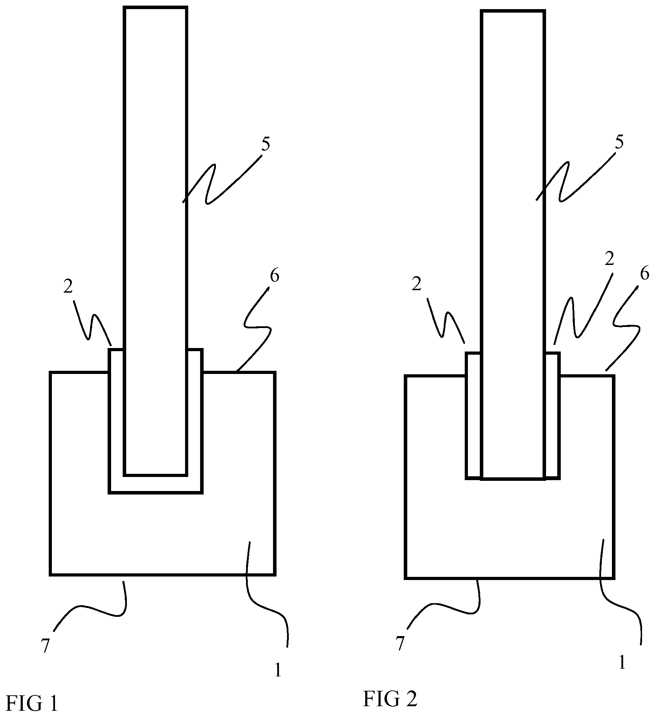

In the following the invention will be described in greater detail by means of preferred embodiments with reference to the attached drawings, in which
Figures 1 to 5 shows different embodiments of the invention.

### DETAILED DESCRIPTION OF THE INVENTION

Figure 1 shows an example of a heatsink according to an embodiment of the present invention. The heatsink comprises a heatsink base 1 and cooling fins 5. In Figure 1 only one cooling fin 5 is shown for simplicity. However, it is clear that a heatsink has multiple of cooling fins. The heatsink base has a first surface 7 and a second surface 6. The first surface 7 is the surface to which a heat source, i.e. the component to be cooled is to be attached. The cooling fins 5 are attached to the heatsink base and are arranged to extend from the heatsink base 1.

The heatsink base comprises a second surface 6, which is typically on the opposite side of the heatsink base compared to the first surface 7. The second surface 6 comprises grooves which are preferably machined to the surface. The cooling fins comprise carbon-based material and a metallic base 2 at one end of the cooling fins. According to the embodiment, the cooling fins are arranged to the grooves on the surface of the heatsink base such that the metallic bases are in the grooves. As shown in Figure 1, the metallic base is arranged in the groove and the cooling fin is in the metallic base. As mentioned above, the example shows only one cooling fin with the metallic base. However, typically multiple of cooling fins are present in a heatsink.

Figure 1 shows a cross section of an embodiment. As shown in the figure, the cross section of the formed grooves is rectangular. Similarly, the metallic base 2 has a rectangular cross section. The cooling fins, which are preferably thin plate-like elements are fitted to the elongated metallic base. Preferably, the grooves in the surface of the heatsink base extend for a whole length of the heatsink base. That is, the grooves extend from one edge of the heatsink base to an opposing edge of the heatsink base. Similarly, each metallic base extends substantially for the length of the grooves. Thus, the metallic base has a length which corresponds to that of the surface of the heatsink base.

The cooling fins, which are plate-like elements, have a length which correspond to the length of the metallic base. The cooling fins are preferably rectangular plates which have a length and a height and a thickness. As mentioned, the length of the cooling fin is the dimension which is in the groove formed in the surface of the heatsink base. The height of the cooling fin is the dimension in which the cooling fin extend from the surface of the heatsink base, and the thickness of the cooling fin is the smallest dimension and the thickness is smaller than the inner diameter of the grooves in the surface of the heatsink base.

According to an embodiment of the present invention, the metallic base extends in the surface of the cooling fin. As the profile of the metallic base rectangular, the bottom of the metallic base is in contact with the plate-like cooling fin. Further, the sides of the metallic base which are connected to the bottom of the metallic base, are in contact with the surface of the cooling fin, and thereby the metallic base extends in is the surface of the cooling fin. Both sides of the metallic base extend preferably for a length which is greater than the depth of the groove in the surface of the heatsink base.

The metallic base has a function of providing support to cooling fins during their installation to the heatsink base. The cooling fins are carbon-based material and may thus be brittle. The cooling fins are therefore first installed to the metallic bases, and the metallic bases are then arranged to the grooves of the heatsink base. Another purpose of the metallic base is to ensure that the heat from the heatsink base is transferred to the cooling fins in an effective manner. This is achieved by fitting the cooling fin tightly to the metallic base and the metallic base to the groove of the heatsink base.

Figure 2 shows another embodiment of the invention. In the embodiment the metallic base 2 is formed of two separate pieces which are situated in the sides of the groove and are thereby against the sides of the plate like cooling fins. The metallic base which is formed of two pieces are metallic plates which extend in the groove. The same reference numerals are used in Figure 2 as in Figure 1.

According to an embodiment of the invention, the metallic base extends in the surface of the cooling fin for a distance which is greater than half of the height of the cooling fin. In an embodiment, the metallic base extends only on one side of the cooling fin. According to another embodiment, the metallic base extends on both sides of the cooling fin. Extended metallic base gives additional protection against mechanical impacts during installation of the cooling fins and during use and installation of the heatsink.

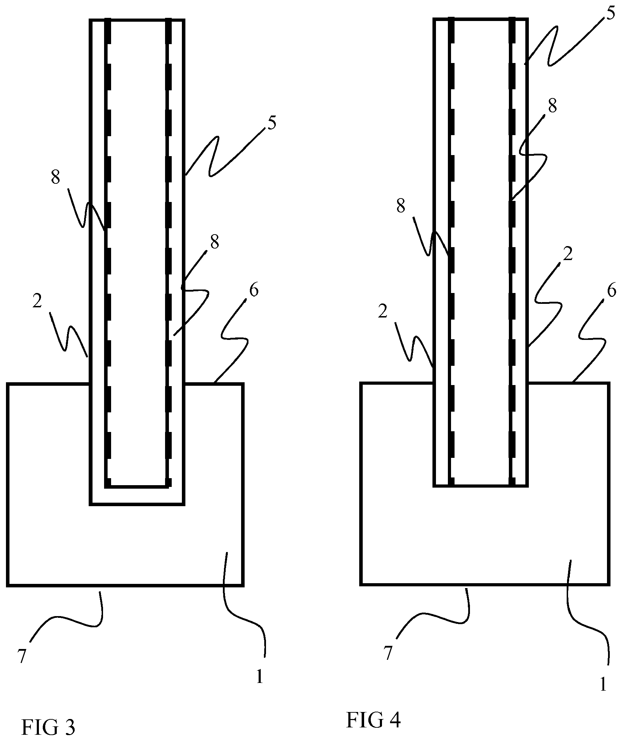

Figures 3 and 4 shows an embodiment in which the metallic base extends for the whole height of the cooling fin on both sides of the cooling fin. The upper ends of the sides of the metallic base are shown to be on the same level as the carbon-based cooling fin. In Figure 3 the metallic base is shown to cover also the edge of the cooling fin which is towards the heatsink base, i.e. the metallic base is formed of a single piece of metal. Figure 4 shows a structure in which the metallic base is formed of two pieces of metal. The two pieces are basically metal plates which cover the surfaces of the cooling fin. The metallic base is preferably attached to the surface of the cooling fin using a heat transferring adhesive layer 8, adhesive tape or by diffusion bonding, for example. In Figures 3 and 4 the same reference numerals are used as in Figure 1 and 2.

Figures 1 to 4 show embodiments in which the structure of the metallic base is varied. In figures 1 and 2, the height of the metallic base is higher than the depth of the groove thus the sides of the metallic base are above the surface of the heatsink base. In Figures 3 and 4, the height of the metallic base corresponds to the height of the cooling fin, i.e. their ends are at a same distance from the surface of the heatsink base. The dimensions of the metallic base are not limited to the two examples. One side of the metallic base may, for example, be shorter than the other side.

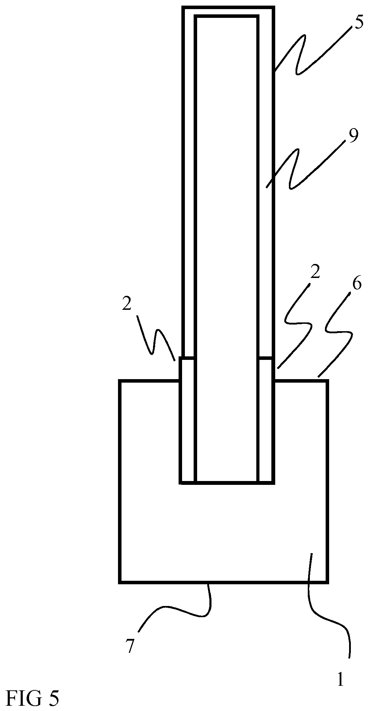

Figure 5 shows another embodiment of the invention. In the embodiment a protective coating is formed on the surface of the cooling fin. The structure of Figure 5 corresponds to that of Figure 2 except for the protective coating. It is, however clear, that protective coating can be applied to the structure of Figure 1 or to any other structure in which the metallic base does not cover the surfaces of the cooling fin. The protective coating is, for example, a polymer coating, such as lacquer. The protective coating increases the mechanical strength of the cooling fin and protects the fin from erosion caused solid particles blown by cooling air.

The cooling fins of the invention are carbon based material and their smallest dimension, i.e. thickness, is preferably in the range of 0.1 mm to 1 mm. The carbon based material is preferably graphene. The cooling fin is formed, for example, by pressing together multiple of graphene sheets which may have a thickness in the range of 100 µm. The sheets may be attached together using diffusion bonding type method using a high temperature and pressure. The resulting sheet is hard and brittle.

Another example is to form a flexible graphene sheet from multiple of sheets having a thickness ranging from 10 to 400 µm by gluing the sheets together. As the resulting sheet is flexible, the structure may include supporting polymer or metallic structures. It is further clear that a carbon based cooling fin may be formed in multiple of other ways than the above two examples. The carbon based material may also be graphite.

Graphite or graphene sheets have excellent thermal properties and they can transfer heat in an efficient manner. The support for the structure may be obtained with a a polymer sheet arranged between the two sets of sheets. The polymer sheet gives additional strength to the structure. The two plates or the two sets of sheets of carbon-based material may be glued or otherwise adhered to the polymer sheet.

According to method of the invention, the method comprises providing a heatsink base having parallel extending grooves in a surface of the heatsink base. The heatsink base is preferably aluminium or copper, and the grooves in the surface are formed preferably by machining. Further in the method, cooling fins comprising carbon-based material are provided and the cooling fins are arranged to metallic bases.

The cooling fins are preferably formed from sheets of carbon-based material, such as graphite or graphene, which are pressed together to form a plate like structure having a desired thickness. The cooling fins or the plates are arranged to metallic bases by placing the plates to the pre-manufactured elongated structures which have a rectangular cross-section with one side open.

The structures having metallic bases, i.e. the cooling fins, are further arranged to the grooves of the heatsink base. As described in detail above, the metallic bases are placed to the grooves formed in the heatsink base.

Preferably the method comprises pressing the heatsink to reduce the width of the grooves of the heatsink base so that mechanical connection between the heatsink base, metallic base and the carbon-based material is tightened. When the mechanical structure is tightened, also the thermal resistance from one part of the structure to another is decreased allowing heat to transfer more easily from the heatsink base to the cooling fins.

The cooling fins are preferably prepared by pressing sheets of carbon-based material together to form a cooling fin and preferably pressing two sets of sheets of carbon-based material together to form carbon-based plates, providing a polymer sheet, attaching the carbon-based plates together with the polymer sheet between them. The polymer sheet or film is placed between two plates of carbon-based material. The plates are formed from thin sheets by pressing the sheets together.

It will be obvious to a person skilled in the art that, as the technology advances, the inventive concept can be implemented in various ways. The invention and its embodiments are not limited to the examples described above but may vary within the scope of the claims.

## Claims

1. A heatsink comprising a heatsink base and cooling fins, wherein
the heatsink base comprises a first surface which is adapted to be attached to a surface of a heat source and
the cooling fins are attached to the heatsink base and arranged to extend from the heatsink base, **characterized in that**
the heatsink base comprises a second surface comprising grooves,
the cooling fins comprise carbon-based material and a metallic base at one end of the fins, and
the cooling fins are arranged to the grooves such that the metallic bases are in the grooves.

2. A heatsink according to claim 1, wherein the cooling fins are plate like elements.

3. A heatsink according to claim 1 or 2, wherein the metallic base extends in the surface of the cooling fin.

4. A heatsink according to claim 1, 2 or 3, wherein the metallic base extends in the surface of the cooling fin in both sides of the cooling fin.

5. A heatsink according to any one of the previous claims 1 to 4, wherein the metallic base extends in the surface of the cooling fin for a length which is greater than the depth of the groove.

6. A heatsink according to any one of the previous claims 1 to 5, wherein the metallic base extends in the surface of the cooling fin for the whole height of the cooling fin.

7. A heatsink according to any one of the previous claims 1 to 6, wherein the cooling fin comprises sheets of carbon-based material which are pressed together.

8. A heatsink according to any one of the previous claims 1 to 7, wherein the cooling fin comprises a polymer sheet arranged in the middle of the cooling fin.

9. A heatsink according to any one of the previous claims 1 to 8, wherein the metallic base is formed of a single piece of metal or from two pieces of metal.

10. A method of manufacturing a heatsink, the method comprising providing a heatsink base having parallel extending grooves in a surface of the heatsink base,
providing cooling fins comprising carbon-based material,
arranging cooling fins to metallic bases, and
arranging cooling fins with metallic bases to the grooves of the heatsink base.

11. A method of manufacturing a heatsink according to claim 10, wherein the method further comprises
pressing the heatsink to reduce the width of the grooves of the heatsink base once the cooling fins with metallic bases are arranged to the grooves.

12. A method of manufacturing a heatsink according to claim 10 or 11, wherein providing cooling fins comprise
pressing sheets of carbon-based material together to form a cooling fin.

13. A method of manufacturing a heatsink according to claim 10 or 11, wherein providing cooling fins comprise
pressing two sets of sheets of carbon-based material together to form carbon-based plates,
providing a polymer sheet,
attaching the carbon-based plates together with the polymer sheet between them.
